# EUROPEAN PATENT APPLICATION

(11) **EP 2 398 145 A1**
(43) Date of publication of application: **21.12.2011**
(21) Application number: 10166529.7
(22) Date of filing: 18.06.2010
(51) Int. Cl.: H03H 9/02

(54) **Microresonator, resonator sensor with such microresonator, sensor array comprising at least two such microresonators and method for making such a microresonator**

(71) Applicant: Stichting IMEC Nederland, 5656 AE Eindhoven (NL)
(72) Inventor: Karakaya, Koray, 5615 CL, Eindhoven (NL); Crego Calama, Mercedes, 5663 PK, Geldrop-Mierlo (NL); Brongersma, Sywert H., 5644 GK, Eindhoven (NL)
(74) Representative: Sarlet, Steven Renaat Irène

(57) **Abstract**

Microresonator (1) for use as a resonator in a detector, the microresonator (1) being provided for resonating in a first predetermined resonance mode, comprising an integrated electronic transducer (2) for measuring deformation of the microresonator (1) in the first predetermined resonance mode of the microresonator (1), characterized in that the transducer (2) is provided at the location of a local deformation (4) of the predetermined resonance mode to measure the deformation of the microresonator at the location of the local deformation (4), the first predetermined resonance mode being one of higher order resonance modes.

Microresonator (1) according to claim 1, characterized in that the microresonator (1) comprises a second integrated electronic transducer (3) for measuring deformation of the microresonator (1) in a second predetermined resonance mode of the microresonator

## Description

### Technical field

The present invention relates to a microresonator as described in the preamble of claim 1.

### Background art

Microcantilevers and their use in sensing applications, e.g. chemical and biological sensing applications, are known from for example Datskos P.G., Lavrik N.V. and Sepaniak M.J., "Chemical and biological sensors based on microcantilevers" in Smart Sensors and MEMS, ed. Yurish S.Y. and Gomes M.T.S.R., Kluwer Academic Publishers pp. 331-379, 2005. Such microcantilevers can have two operation modes, *i.e.* static and dynamic (resonant). In resonant mode, analysis is performed by monitoring resonance frequency shifts of the resonating microcantilever or micro resonator of any kind.

The resonance frequency of the microresonator (ω*₀*) is a function of the microresonator stiffness *(k₀)* and mass *(m₀).* Therefore any change in the mass (Δ*m*/*m₀*) (for example; by means of precipitation, binding, absorption/adsorption, desorption, evaporation, deposition, etc.), as well as a change of the microresonator stiffness (Δ*k*/*k₀),* cause a shift in the resonance frequency (Δω/ω*₀*). Binding of specific molecules, atoms, particles, organic cells, etc. on the resonating structure can be monitored by monitoring the resonance frequency of the microresonator. Therefore, such microresonators are useful in sensing applications.

Resonant structures, such as e.g. cantilevers, bridges or membranes, have a number of resonance vibration modes called 'mode shapes'. Each mode shape has a specific deformation pattern of the resonating structure at a particular frequency, depending on the properties of the resonating structure. At each mode shape of a given resonator, localized deformations on various positions of the structure can be observed, such as for example local maxima and minima. For example, for resonant microcantilevers, beams and membranes, different mode shapes cause localised deformations on various positions of the resonating structure.

Increased mass sensitivity of resonant sensors at higher order resonance modes has been reported previously. In Yi J.W., Shih W.Y and Shih W-H., "Effect of length, width and mode on the mass detection sensitivity of piezoelectric unimorph cantilevers", Journal of Applied Physics, vol. 91, pp. 1680-1686, 2002 and in "Enhanced functionality of cantilever based mass sensors using higher modes", Søren Dohn, Rasmus Sandberg, Winnie Svendsen, and Anja Boisen, Applied Physics Letters, Volume 86, 233501 (2005) it has been reported, both theoretically and experimentally, that the sensitivity of a cantilever-based mass sensor to a point mass can be higher for higher-order resonance modes than for the fundamental or first mode shape.

It has been shown by M.K. Ghatkesar, V. Barwich, T. Braun, J. Ramseyer, C. Gerber, M. Hegner, H.P. Lang, U. Drechsler, and M. Despont in "Higher modes of vibration increase mass sensitivity in nanomechanical microcantilevers", Nanotechnology, vol. 18, p. 445502, 2007 that also for vibrating cantilevers with a distributed mass load, the change in resonance frequency (and thus the sensitivity) increases with increasing mode number.

There are two major approaches for electrical transduction of deformations of a resonating structure with integrated, for example electronic, transducers: a first approach is using for example piezoelectric or piezoresistive transducers, wherein the electrical signal is generated by deformation of the transducers integrated with the resonating structure. In a second approach, for example with capacitive or magnetic transducers integrated with the resonating body, relative displacement of the resonating body against a counterpart (e.g. the counter electrode for electrostatic detection, permanent magnet and/or coils for magnetic detection, etc.) is used for monitoring the movement of a resonating structure.

In "Laser vibrometry and impedance characterization of piezoelectric microcantilevers", J. Micromech. Microeng., 17 (2007) 931-937 by P Sanz, J Hernando, J Vázquez and J L Sánchez-Rojas, the frequency response of microcantilevers above the first resonance mode is further described. The vibration response of a ZnO-based piezoelectric cantilever is studied for seven resonance modes. Herein, the microcantilever consists of a piezoelectric ZnO layer between two Ti/Au metal electrodes covering the entire surface of a non-piezoelectric silicon supporting layer. The frequencies and the mode shape of the first seven resonances of the cantilever are measured by laser vibrometry. In addition, the impedance analysis of the first seven resonances is also performed. It is observed that higher-order resonance modes have relatively low displacement as measured optically. Moreover, they also showed lower signal amplitude as measured through the transducer by impedance analysis. Some higher-order resonance modes, for example the fifth and the second, were even only detectable optically (by using a laser Doppler interferometer) and showed null response during impedance analysis, due to the deformation pattern of these mode shapes featuring an anti-symmetric torsional component and the subsequent compensation of the piezoelectrically generated charges generated under simultaneous presence of tensile and compressively strained regions of the piezoelectric stack.

Although the sensitivity of resonating microcantilevers increases at higher resonance modes, the signal amplitude generated by the transducer is generally lower than the signal acquired at lower resonance modes, because absolute physical displacement decreases for higher-order resonance modes. Therefore achieving a good signal-to-noise ratio becomes more difficult at high resonance modes. In addition to that, inhomogeneous or even anti-symmetric deformation of the resonator at higher order resonance modes causes degradation or even total loss of the signal as described in previous paragraph. For example, when using a piezoelectric transducer covering a substantial part of the surface of a microcantilever, inhomogeneous or even anti-symmetric deformation of the cantilever leads to charge neutralization between tensile and compressive strained areas and thus a decreased signal amplitude. Therefore, it is not efficiently possible, or for some cases not even possible at all, with the known methods to efficiently measure deformation of the microresonator with an integrated transducer, without having to use additional bulky equipment such as for example a Doppler interferometer.

### Disclosure of the invention

It is therefore an aim of the current invention to provide a microresonator comprising at least one transducer with which it is possible to efficiently measure deformation of the microresonator in at least one predetermined resonance mode of the microresonator, such as for example a resonance mode with an inhomogeneous deformation of the microresonator.

This aim is achieved according to the invention with the microresonator showing the technical features of the first claim.

Thereto, the transducer is provided at the location of a local deformation, preferably a single local extremum in deformation, of the predetermined resonance mode to measure the deformation of the microresonator at the location of the local deformation, e.g. local extremum, the first predetermined resonance mode being one of the higher order resonance modes.

Since the transducer is located at the location of the local deformation, e.g. a local extremum, an accurate measurement of the deformation of the microresonator, e.g. at the local extremum, is possible, even for resonance modes with an inhomogeneous deformation, especially when the transducer is located at the location of a single local deformation. For example, in such a configuration charge neutralization between tensile and compressive strained areas can be avoided as the transducer is now located at the location of a local deformation and preferably a single local deformation as in such case other local deformations have no or very limited influence on the measurement of the deformation of the microresonator.

As the transducer is integrated with the microresonator, this leads to less bulky equipment but nevertheless allows an efficient measurement of the deformation of the microresonator in the predetermined resonance mode of the microresonator. Since higher-order resonance modes, resonance modes of at least the second order resonance mode, can be measured more efficiently without having to use additional bulky equipment such as for example Doppler interferometers, sensing applications, such as resonator sensors, using the microresonator can also be made more compact.

In preferred embodiments of the microresonator according to the present invention, the microresonator comprises a second integrated electronic transducer for measuring deformation of the microresonator in a second one of the predetermined resonance modes of the microresonator, the second transducer being provided at the location of a second different local deformation, preferably a second local extremum in deformation, of the second predetermined resonance mode to measure the deformation of the microresonator at the location of the second local deformation, preferably the second local extremum. As with the first transducer, since the transducer is located at the location of a local deformation, e.g. a local extremum, an accurate measurement of the deformation of the microresonator, e.g. at the local extremum, is possible, even for resonance modes with an inhomogeneous deformation, especially when the transducer is located at the location of a single local deformation.

As the second transducer, like the first transducer, is integrated with the microresonator, this leads to less bulky equipment but nevertheless allows an efficient measurement of the deformation of the microresonator in the predetermined resonance mode of the microresonator.

Such a microresonator allows a more precise measurement of the predetermined resonance modes of the microresonator and therefore, for example, allows a more precise measurement of a frequency shift due to a change of mass and/or stiffness of the microresonator. This allows measuring relatively small changes in the mass and/or the thickness of the microresonator.

With such microresonators comprising a first transducer and a second transducer, it becomes for example possible to use a single microresonator in sensor applications with multiple sensitivity scale operations. For example, the second resonance mode can be of a lower order than the first resonance mode, corresponding to lower resonance frequencies which can for example be used for a low sensitivity scale, i.e. a rough analysis, whereas the first resonance mode can for example be used for a higher order resonance mode at a higher frequency for a more sensitive scale, i.e. a finer analysis. However, the second resonance mode can also equal the first resonance mode in which case the microresonator can for example be used for more accurate measurements of the deformation of the microresonator.

The first predetermined resonance mode in other words can be any one of the resonance modes of the microresonator from the second order resonance mode upwards, such as for example the second order, the third order, the fourth order, the fifth order, the sixth order, the seventh order, the eighth order, the ninth order, the tenth order, the eleventh order the twelfth, order the thirteenth order, etc. resonance mode of the microresonator.

The second predetermined resonance mode in other words can be any one of the resonance modes of the microresonator from the first order resonance mode upwards, such as for example the first order, the second order, the third order, the fourth order, the fifth order, the sixth order, the seventh order, the eighth order, the ninth order, the tenth order, the eleventh order, the twelfth order, the thirteenth order, etc. resonance mode of the microresonator.

As indicated above, in preferred embodiments of the microresonator according to the present invention, the first and/or second local deformation preferably is a local extremum in deformation of the predetermined resonance mode. It has been found that when the first and/or second local deformation is a local extremum, respectively called first local extremum and second local extremum, the signal to noise ratio further increases due to the relatively large local deformation of the microcantilever. The number of individual transducers present on the resonator can be selected depending on the number of predetermined resonance modes and their mode shapes, actuation requirements and can be as many as required.

In further preferred embodiments of the microresonator according to the present invention, the respective transducers comprise a respective layer of piezoelectric material sandwiched between two respective measuring electrodes. Alternatively, the respective transducers comprise a respective layer of piezoelectric material with respective interdigitated electrodes at one side of the layer of piezoelectric material. Such transducers are relatively easy to fabricate and allow a relative precise measurement of the deformation of the microresonator at the first and the second location while being relatively robust and are far less bulky than, for example, Doppler interferometers. In further preferred embodiments of the microresonator according to the present invention, the piezoelectric material is chosen from the group of for example ZnO, PZT (lead zirconate titanate, (Pb[Zr*ₓ*Ti_{1-*x*}]O₃ with 0<*x*<1) posibly with dopants), and AIN (aluminium nitride). In another preferred embodiment, the resonator itself can be at least part of the piezoelectric transducer, such as for example discussed in "Multifunctional Nanomechanical Systems via Tunably Coupled Piezoelectric Actuation" by C. Masmanidis, Rassul B. Karabalin, Iwijn De Vlaminck, Gustaaf Borghs, Mark R. Freeman, Michael L. Roukes in Science, vol 317. Piezoelectric transducers integrated with the resonator can be fabricated using a single material combination for all transducers. However, it is also part of the invention that if a transducer is used specifically for actuation of the resonator, then this can be fabricated with a material combination with better actuation characteristics. In addition to that, transducers used for sensing the deformation of the resonator, can be fabricated with the materials that have a better sensing characteristics. Selecting the suitable piezoelectric material for aforementioned sensing and actuating transducers can be done for example by a figure-of-merit defined for actuation and sensing, as for example described in Trolier-McKinstry S. and Muralt P., "Thin film piezoelectrics for MEMS", Journal of Electroceramics, vol. 12, pp. 7-17, 2004. From this publication the inventor has realized that as PZT has a relative large voltage-to-mechanical conversion capability definied by the d (more in particular *d*₃₃,*_{f}*) coefficient in the publication it is very suitable for use as an actuator. Moreover, from this publication the inventor has realized that as AIN has a relatively good signal amplitude (*e*₃₁,_{f}/ε₀ε₀₃₃) and has a relatively good signal-to-noise ratio (*e*₃₁,_{f}(ε₀ε₃₃tanδ)^{-1/2}) in the publication it is very suitable for use as a sensor. Therefore, for example the transducer used for actuation can be fabricated by using PZT as piezoelectric material with better actuation characteristics, whereas AIN is used as the piezoelectric material for sensing transducer, for transducing the deformations to electric signals.

Other types of transduction mechanisms, such as electrostatic, electromagnetic, piezoresistive, electrooptic, etc., can also be used for transducing the deformations of the resonator into electrical signals. A combination of these transducer types can also be used together, for example piezoelectric and electrostatic, piezoelectric and piezoresistive, piezoresistive and electrostatic, piezoelectric and electromagnetic, electrostatic and electrooptic, etc.

In embodiments of the microresonator according to the present invention, the microresonator may employ a geometrical irregularity, such as for example a protrusion extending from the remainder of the microresonator for manipulating the amplitude of a predetermined local deformation. It has been described in for example Salehi-Kojin A., Bashash S., Jalili N., Muller M. and Berger R., "Nanomechanical cantilever active probes for ultrasmall mass detection", Journal of Applied Physics, vol. 105, p. 013506, 2009 that such a protrusion helps generating relatively large local deformations of the microcantilever for some of the resonance modes. The inventor has found that a combination of multiple transducers placed for capturing these relatively large deformations can lead to a better signal-to-noise ratio and the measurement of the resonance mode can be made even more precise for selected resonance modes.

The invention also relates to a resonator sensor comprising a microresonator according to the invention.

The invention also relates to a sensor array comprising at least two microresonators according to the invention, each of said microresonators having different resonance modes. Such a configuration for example allows a simultaneous measurement with different microresonators having substantially the same physical/chemical interactions with their surroundings but substantially operating in different resonance modes such that simultaneous measurements with different accuracies are obtained. The at least two microresonators can have a same geometry with different dimensions, for example for enhancing the resonance frequency coverage. The at least two microresonators can have different geometries, for example different geometries with a same surface area where mass loading can occur such as to obtain comparable measurements with the different microresonators. Microresonators with different geometries can also be used for manipulating a particular mode shape of a predefined resonance mode. At least two microresonators with a first comprising a first transducer type, for example, piezoelectric, piezoresistive, electrostatic, electromagnetic, etc., and a second microresonator(s) comprising another transducer type can also form an array. Any possible combination of different transducer with different transduction mechanisms can be present in a resonator array.

The invention also relates to a method for making a microresonator according to the invention, comprising the steps of analyzing at least one resonance mode of a microresonator, for example by calculating or numerically modeling a model for the microresonator, finding at least one location of the microresonator comprising a local deformation, preferably a local extremum, of the analyzed resonance mode and integrating an electronic transducer with the microresonator for measuring deformation of the microresonator at the location. The inventor has found that such a method allows making a microresonator designed to operate in a given resonance mode allowing a measurement of the deformation of the microresonator at specific location such that a specific resonance mode can be measured and monitored.

### Brief description of the drawings

The invention will be further elucidated by means of the following description and the appended figures.
Figure 1 a shows an overview of a first embodiment of a microresonator according to the present invention.
Figure 1b shows a top view of the microresonator according to figure 1a.
Figure 1c shows a cross-section of a detail of figure 1b.
Figure 2 shows an overview of a second embodiment of a microresonator according to the present invention.
Figure 3 shows an overview of a third embodiment of a microresonator according to the present invention.
Figure 4 show a top view of a fourth embodiment of a microresonator according to the present invention.
Figure 5a - f show an overview of some embodiments of the microresonator according to the invention.
Figure 6 shows a different configuration for the microresonator according to the current invention.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

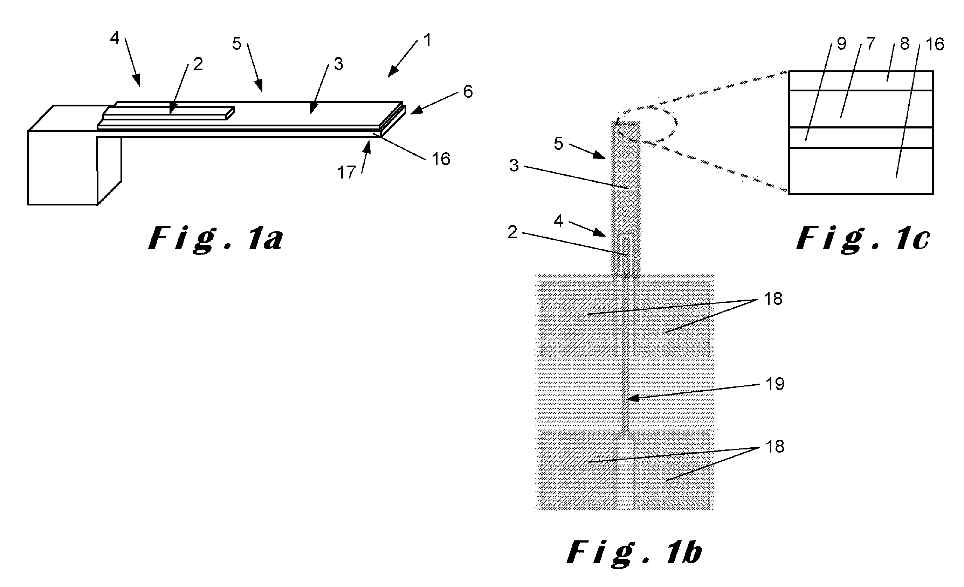

Figures 1a and 1b show a first embodiment of the microresonator 1 according to the present invention. The microresonator 1 is provided for use as a resonator in a detector, for example a mass absorption, desorption, adsorption, physi-/chemisorption or a detector for detecting a change in the surface stress gradient or stress gradient within the resonator in general, achieved by stiffening or softening of one of the materials of the resonator structure, formation of an additional layer (e.g. a biomolecule layer) on the resonator, or chemical reactions occuring on and/or around the resonator causing local temperature changes (i.e. by exothermic or endothermic reactions, by evaporation of a volatile reaction product, etc.). The sensitivity obtained with such a resonator for example lies with the range of between femtograms and grams kg.

The microresonator 1 is provided for resonating in a first predetermined resonance mode. The first resonance mode is one of higher order resonance modes and the first resonance mode in other words can be any one of the resonance modes of the microresonator from the second order resonance mode upwards, such as for example the second order, the third order, the fourth order, the fifth order, the sixth order, the seventh order, the eighth order, the ninth order, the tenth order, the eleventh order, the twelfth order, the thirteenth order, etc. resonance mode of the microresonator.

The microresonator 1 shown in the figures is a cantilever. This is however not critical for the invention and the microresonator 1 can for example also be a bridge or a membrane or any other type of resonator design in the micrometer and/or nanometer range. A microresonator is a resonator of which length and width is above 250nm while a nanoresonator is a resonator of which length and/or width is below 250 nm. Therefore the invention covers cantilevers, doubly clamped beams, membranes or any possible form of resonator in the micrometer and/or nanometer range. Cantilevers are however preferred as they present a relative large deformation as compared to, for example, clamped structures such as for example doubly clamped beams, membranes, etc. and moreover are relatively easy to make.

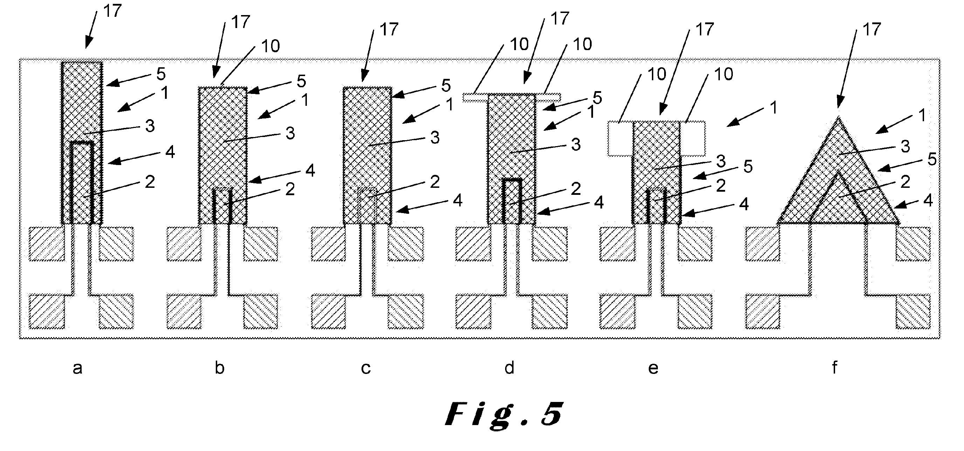

The microresonator 1 comprises a transducer 2 at a predetermined location, taking into account the predetermined resonance mode, on the surface 6 of the cantilever. The microcantilever 1 shown in figure 1 a comprises a beam 16 clamped at one longitudinal end and being free to vibrate at an opposing end 17. However other forms are possible as for example is shown in figure 5.

The surface 6 of the microresonator 1 shown in the figures is substantially planar when the microresonator 1 is not vibrating. Moreover, the microresonator 1 has substantially a uniform thickness. This is however not critical for the invention and the surface 6 and the thickness of the microresonator 1 can be determined in function of the desired characteristics of the microresonator 1.

The shown microresonator 1 comprises an electronic transducer 2 positioned along its surface 6 for measuring deformation of the microresonator 1 in the first predetermined resonance mode of the microresonator 1. Although such a transducer 2 is easy to apply, any other way of embedding the transducer 2 is possible. For example, the electronic transducer 2 can be provided in the interior of the microresonator 1, for example fully, covered by other materials and/or components of the microresonator 1.

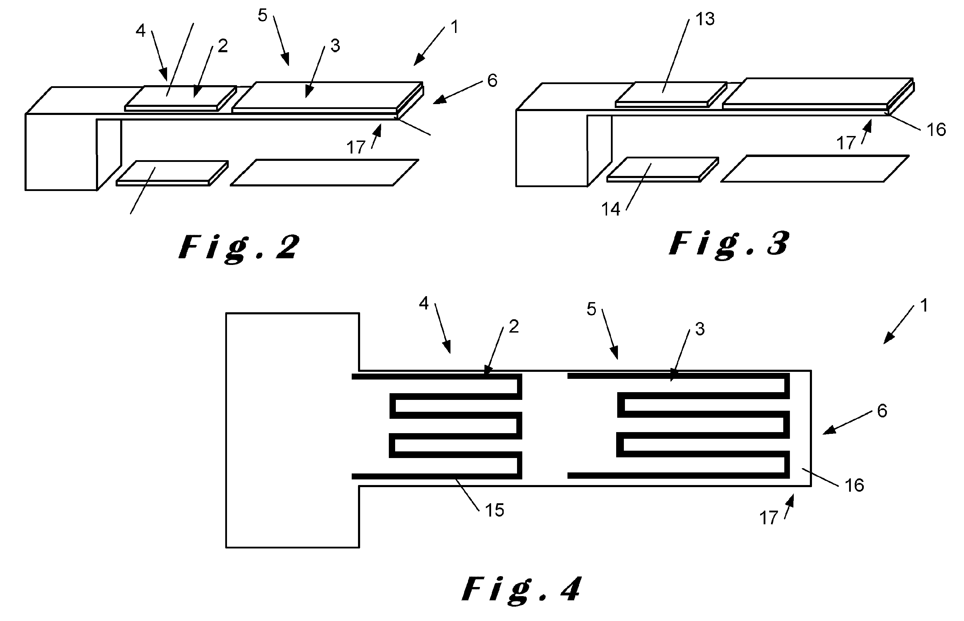

The electronic transducer 2 shown in figure 1 a and 1 b is a piezoelectric transducer 2. However, also other transducers are possible as shown in figures 2 to 4 in which the transducer 2 respectively is a capacitive transducer, magnetic transducer and a piezoresistive transducer. However, other transducers, although not shown, are also possible.

The first transducer 2 is substantially provided at the location of a local deformation 4 of the predetermined resonance mode, more specifically a single local deformation 4, to measure the deformation of the microresonator at the location of the local deformation 4. Especially local deformations of resonance modes due to their shape featuring inhomogeneous deformation resulting in stress of opposite sign on the surface of the piezoelectric layer and charge compensation are detectable using the transducer 2 at such a location. Also, as explained above, the location of the local deformation 4 preferably is a local extremum in deformation of the predetermined resonance mode. This is however not shown in the figures and the figures only show a schematic overview of the microresonator.

Figure 1a and 1b further shows a second electronic transducer 3 positioned along the surface 6 for measuring deformation of the microresonator 1 in a second predetermined resonance mode of the microresonator 1. Although such a transducer 3 is easy to apply, any other way of embedding the transducer 3 is possible. For example, the electronic transducer 3 can be provided in the interior of the microresonator 1, for example fully, covered by other materials and/or components of the microresonator 1. The second transducer 3 is preferably substantially provided at the location of a second different local deformation 5 of the second predetermined resonance mode, more specifically a single local deformation 5, to measure the deformation of the microresonator 1 at the location of the second local deformation 5.

Such a multiple transducer approach can bring additional advantages for clamped-clamped or membrane-like structures: For example in case of piezoelectric transducers, applying a DC potential can change the stiffness of the structure and can be used for tuning the resonance frequency. This brings another degree of freedom in device design and operation.

The second electronic transducer 3 shown in figure 1a and 1b is a piezoelectric transducer 3. However, also other transducers are possible as shown in figures 2 to 4 in which the second transducer 3 respectively is a capacitive transducer, magnetic transducer and a piezoresistive transducer. However, other transducers, although not shown, are also possible.

The second transducer 3 is substantially provided at the location of a local deformation 5 of the predetermined resonance mode, more specifically a single local deformation 5, to measure the deformation of the microresonator 1 at the location of the local deformation 5. Especially local deformations of resonance modes due to their shape featuring inhomogeneous deformation resulting in stress of opposite sign on the surface of the piezoelectric layer and charge compensation are detectable using the second transducer 3 at such a location. Also, as explained above, the location of the local deformation 5 preferably is a local extremum in deformation of the predetermined resonance mode. This is however not shown in the figures and the figures only show a schematic overview of the microresonator.

Although in all figures the first and the second transducer 2, 3 are both similar and more in particular are both piezoelectric transducers, capacitive transducers, magnetic transducers, piezoresistive transducers, this is not critical for the invention and the first and the second transducer can be different and combinations of different types of transducers are possible such as for example a piezoelectric transducer with a capacitive transducer, magnetic transducer or a piezoresistive transducer.

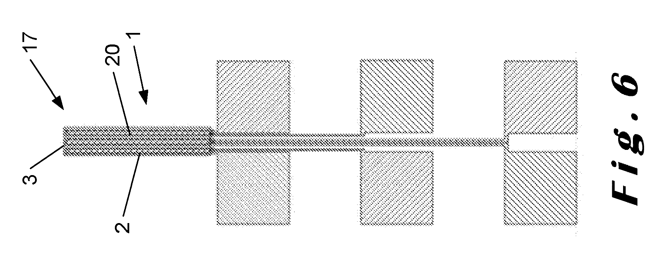

Although the figures show two transducers, this is not critical for the invention and also more transducers are possible to measure the deformation of the microresonator 1 at further locations. Figure 6 for example shows a top view of microcantilever 1 comprising three transducers 2, 3, 20. The transducers 2, 3, 20 extend adjacently and longitudinally along length direction of the microcantilever 1. Such a configuration of the three transducers 2, 3, 20 is not critical for the invention and other configuration are possible.

Although the figures show a plurality of transducers, this is not critical for the invention and a single transducer 2 can be sufficient.

Figure 1c further shows an example of the structure of the piezoelectric transducer 2. The piezoelectric transducer 2 comprises a layer of piezoelectric material 7 sandwiched between two respective measuring electrodes 8, 9. The electrodes are arranged such that electrical potential differences between the top surface of the piezoelectric layer 7 and the bottom of the piezoelectric layer 7 caused by strain in the piezoelectric layer, are transferred by respectively the top 8 and the bottom 9 electrodes such that they can be measured in order to establish the deformation of the microcantilever 1 at the first location, and in this case also the second location.

Preferably, the piezoelectric material is chosen from the group of ZnO, PZT (lead zirconate titanate or (Pb[Z*ₓ*Ti_{1-*x*}]O₃ with 0<x<1)) and AIN (aluminium nitride). However, any other type of suitable piezoelectric material known to the person skilled in the art can be used.

Figure 1b shows a top view of the microcantilever 1 shown in figure 1 a and shows the position of the first and second transducers 2, 3 in more detail. It can be seen that the first transducer 2 is positioned near the location where the beam 16 of the cantilever is clamped to the remainder of the microcantilever 1. The second transducer 3 is positioned near the tip of the beam 16. The measuring electrodes of both transducers 2, 3 are connected to bond pads 18 through conductive pathways 19.

Figure 2 shows a microcantilever 1 in which both transducers 2, 3 are capacitive transducers. The capacitive transducer 2, 3 shown in figure 2 are made by applying a first electrode 11 on the surface 6 of the microresonator 1 and applying a second electrode 12 with respect to the first electrode 11 such that deformation of the microresonator 1 at the location of the first electrode 11 changes the distance between the first 11 and the second 12 electrode and therefore the capacity between the first 11 and the second 12 electrode such that an electric signal representing the deformation of the microresonator 1 at the location of the first electrode 11 can be measured.

Figure 3 shows a microcantilever 1 in which both transducers 2, 3 are magnetic transducers, in particular the transducers 2, 3 comprise a pair of magnetic material and a magnetic detector for detecting the magnetic field emitted by the magnetic material. The magnetic transducers 2, 3 shown in figure 3 can be made by applying a thin film permanent magnet 13, magnetic material, along the surface 6 of the microcantilever 1 and providing a magnetic sensor 14, such as for example a coil or a giant magnetoresistance device, a colossal magnetoresistance device, a magnetic tunnel junction, or any kind of device that responds to the changes in the magnetic field etc., placed to the proximity of the microresonator 1 with respect to the thin film permanent magnet 13 such that deformation of the microresonator 1 at the location of the thin film permanent magnet 13 changes the distance between the thin film permanent magnet 13 and the magnetic sensor 14 and therefore the magnetic field measured by the magnetic sensor 14 such that an electric signal representing the deformation of the microresonator 1 at the location of the thin film permanent magnet 13 can be measured. However, although not shown, the magnetic sensor can also be applied along the surface 6 of the microresonator 1 and the thin film permanent magnet away from the microresonator 1. However, it has been found that the thin film permanent magnet 13 is more easily applied along the surface of the microresonator 1 than a magnetic sensor such as for example a coil.

Figure 4 shows a microcantilever 1 in which both transducers 2, 3 are piezoresistive; in particular the transducers 2, 3 comprise a piezoresistive wire 15 along the surface 6 of the microcantilever 1. The piezoresistive wire 15 is arranged such that a deformation of the microresonator 1 at the location of the piezoresistive wire 15 causes a measurable electrical signal. Although it is shown as wires on the resonator, any possible material and device configuration that changes its resistance with strain can be used as a piezoresistive transducer.

The transducers 2, 3 shown in figures 1 and 4 have the advantage that substantially the whole transducer 2, 3 is integrated with the microresonator 1 resulting in a compact microcantilever 1 whereas the transducers 2, 3 shown in figures 2 and 3 require an additional part next to the part located along the surface 6 of the microresonator 1. In all cases mentioned above, the transducer 2, 3 can be used to, next to measure the deformation of the microresonator 1, deform the microresonator 1 at the location of the transducer 2, 3 and can, for example, be used to drive the vibration of the microresonator 1 in a resonance mode. For example by giving electric current pulses on a piezoresistive wire local temperature changes are caused, such that local thermal contraction and expansion can drive the transducer.

One or more than one of the transducers integrated with the resonator can be used for tuning and/or changing one or more of the resonance frequencies by for example changing the moment of inertia of the resonator (e.g. changing the curvature of a resonating beam); by generating axial load (tensile or compressive) for a clamped-clamped or membrane type resonator; by changing the local stiffness for example locally manipulating the temperature of a particular area of the resonator; by applying an auxiliary force on the resonator by electrostatic or electromagnetic methods or by any other means of manipulating one or more of the resonance frequencies of the resonator.

Figure 5 shows an overview of some different shaped microresonators 1. The different microresonators comprise a different shape such as for example rectangular, possibly in different dimensions (figure 5a and figure 5c), triangular (figure 5f), etc. A protrusion 10 such as for example an extended tip (figure 5b), a hammerhead design (figure 5d and 5e), etc. or a point mass, a functional area that causes cross sectional and/or geometrical irregularity can be used for promoting the amplitude of local deformations at a given resonance mode, etc.The invention also relates to a resonator sensor comprising a microresonator 1 as described above.

The invention also relates to a sensor array comprising at least two microresonators 1 as described above each of the microresonators 1 having different resonance modes due to, for example, different shapes (rectangular, triangular, etc.), different extended tips, hammerhead designs, point masses, functional areas, tapered and reversely tapered shapes, etc.

The invention also relates to a method for making a microresonator 1 as described above comprising the steps of analyzing at least one resonance mode of a microresonator 1, finding at least one location 4, 5 of the microresonator 1 comprising a local deformation of the analyzed resonance mode and providing an electronic transducer integrated with the microresonator 1 for measuring deformation of the microresonator 1 at the location 4, 5. The local deformation of the analyzed resonance mode can for example be found using for example optical methods or finite elements calculating methods.

Preferably, analyzing the at least one resonance mode of the microresonator 1 is done by, for example, in a first step making a model of the microresonator 1 and calculating the resonance modes, for example using finite elements. In a next step a model is for example made of the microresonator 1 with a transducer 2 applied on the location of the local deformation after which the resonance modes are again calculated, for example using finite elements, to determine the influence of the presence of the transducer 2. This process can be repeated until the transducer 2 is located at the desired location for measuring deformation of the microresonator 1 at the location 4, 5 which preferably is at the location of a local extremum of the microresonator with the integrated transducer. The step of analyzing the at least one resonance mode of the microresonator can in other words be seen as an iterative process.

## Claims

1. Microresonator (1) for use as a resonator in a detector, the microresonator (1) being provided for resonating in a first predetermined resonance mode, comprising an integrated electronic transducer (2) for measuring deformation of the microresonator (1) in the first predetermined resonance mode of the microresonator (1), **characterized in that** the transducer (2) is provided at the location of a local deformation (4) of the predetermined resonance mode to measure the deformation of the microresonator at the location of the local deformation (4), the first predetermined resonance mode being one of higher order resonance modes.

2. Microresonator (1) according to claim 1, **characterized in that** the microresonator (1) comprises a second integrated electronic transducer (3) for measuring deformation of the microresonator (1) in a second predetermined resonance mode of the microresonator, the second transducer (3) being provided at the location of a second different local deformation (5) of the second predetermined resonance mode to measure the deformation of the microresonator (1) at the location of the second local deformation (5).

3. Microresonator (1) according to claim 1 or 2, **characterized in that** the first (4) and/or second (5) local deformation is a local extremum in deformation of the predetermined resonance mode.

4. Microresonator (1) according to claim 3, **characterized in that** the second predetermined resonance mode is of a lower order than the first predetermined resonance mode.

5. Microresonator (1) according to claim 4, **characterized in that** the second predetermined resonance mode equals the first predetermined resonance mode.

6. Microresonator (1) as claimed in any one of claims 1 - 5, **characterized in that** the transducer (2, 3) comprises a layer of piezoelectric material (7) sandwiched between two respective measuring electrodes (8, 9).

7. Microresonator (1) as claimed in claim 6, **characterized in that** the piezoelectric material is chosen from the group of ZnO, PZT (lead zirconate titanate or (Pb[ZrₓTi₁₋ₓ]O₃ with 0<x<1)) and AIN (aluminium nitride).

8. Microresonator (1) as claimed in any one of claims 1 ― 5, **characterized in that** the transducer (2, 3) is a magnetic transducer.

9. Microresonator (1) as claimed in any one of claims 1 ― 5, **characterized in that** the transducer (2, 3) is a capacitive transducer.

10. Microresonator (1) as claimed in any one of the preceding claims, **characterized in that** the microresonator (1) comprises a protrusion (10) extending from the remainder of the microresonator (1) that causes cross sectional and/or geometrical irregularity for promoting the amplitude of local deformations at a given resonance mode.

11. Microresonator (1) as claimed in any one of the preceding claims, **characterized in that** the microresonator (1) is a microcantilever.

12. Resonator sensor comprising a microresonator (1) according to any one of the preceding claims.

13. Sensor array comprising at least two microresonators (1) as claimed in any one of claims 1 ― 11, each of said microresonators (1) having different resonance modes.

14. Method for making a microresonator (1) as claimed in any one of claims 1 ― 11, comprising the steps of analyzing at least one resonance mode of a microresonator (1), finding at least one location (4, 5) at the surface (6) of the microresonator (1) comprising a local deformation of the analyzed resonance mode and integrating an electronic transducer for measuring deformation of the microresonator (1) at the location (4, 5).

15. Method for making a microresonator (1) as claimed in claim 14, **characterized in that** the local deformation is a local extremum.

## Amended claims

### Amended claims in accordance with Rule 137(2) EPC.

**1.** Microresonator (1) for use as a resonator in a detector, wherein the microresonator (1) is a microcantilever, the microresonator (1) being provided for resonating in a first predetermined resonance mode, comprising an integrated electronic transducer (2) for measuring deformation of the microresonator (1) in the first predetermined resonance mode of the microresonator (1), **characterized in that** the transducer (2) is provided at the location of a local deformation (4) of the predetermined resonance mode to measure the deformation of the microresonator at the location of the local deformation (4), the first predetermined resonance mode being one of higher order resonance modes.

**2.** Microresonator (1) according to claim 1, **characterized in that** the microresonator (1) comprises a second integrated electronic transducer (3) for measuring deformation of the microresonator (1) in a second predetermined resonance mode of the microresonator, the second transducer (3) being provided at the location of a second different local deformation (5) of the second predetermined resonance mode to measure the deformation of the microresonator (1) at the location of the second local deformation (5).

**3.** Microresonator (1) according to claim 1 or 2, **characterized in that** the first (4) and/or second (5) local deformation is a local extremum in deformation of the predetermined resonance mode.

**4.** Microresonator (1) according to claim 3, **characterized in that** the second predetermined resonance mode is of a lower order than the first predetermined resonance mode.

**5.** Microresonator (1) according to claim 4, **characterized in that** the second predetermined resonance mode equals the first predetermined resonance mode.

**6.** Microresonator (1) as claimed in any one of claims 1 - 5, **characterized in that** the transducer (2, 3) comprises a layer of piezoelectric material (7) sandwiched between two respective measuring electrodes (8, 9).

**7.** Microresonator (1) as claimed in claim 6, **characterized in that** the piezoelectric material is chosen from the group of ZnO, PZT (lead zirconate titanate or (Pb[Zr*ₓ*Ti_{1-*x*}]O₃ with 0<*x*<1)) and AlN (aluminium nitride).

**8.** Microresonator (1) as claimed in any one of claims 1-5, **characterized in that** the transducer (2, 3) is a magnetic transducer.

**9.** Microresonator (1) as claimed in any one of claims 1-5, **characterized in that** the transducer (2, 3) is a capacitive transducer.

**10.** Microresonator (1) as claimed in any one of the preceding claims, **characterized in that** the microresonator (1) comprises a protrusion (10) extending from the remainder of the microresonator (1) that causes cross sectional and/or geometrical irregularity for promoting the amplitude of local deformations at a given resonance mode.

**11.** Resonator sensor comprising a microresonator (1) according to any one of the preceding claims.

**12.** Sensor array comprising at least two microresonators (1) as claimed in any one of claims 1 - 1 0, each of said microresonators (1) having different resonance modes.

**13.** Method for making a microresonator (1), the microresonator being a microcantilever,as claimed in any one of claims 1 - 10, comprising the steps of analyzing at least one resonance mode of a microresonator (1), finding at least one location (4, 5) at the surface (6) of the microresonator (1) comprising a local deformation of the analyzed resonance mode and integrating an electronic transducer for measuring deformation of the microresonator (1) at the location (4, 5).

**14.** Method for making a microresonator (1) as claimed in claim 13, **characterized in that** the local deformation is a local extremum.
